(19)

Europäisches
Patentamt
European
Patent Office
Office européen
des brevets

(11) **EP 2 283 372 B1**

(12) **EUROPEAN PATENT SPECIFICATION**

(45) Date of publication and mention
of the grant of the patent:
**08.08.2018  Bulletin 2018/32**

(51) Int Cl.:
***G01R 31/08*** *(2006.01)*

(21) Application number: **09732641.7**

(86) International application number:
**PCT/EP2009/054563**

(22) Date of filing: **16.04.2009**

(87) International publication number:
**WO 2009/127706 (22.10.2009 Gazette 2009/43)**

(54) **A SYSTEM AND METHOD FOR LOCATING LINE FAULTS IN A MEDIUM VOLTAGE NETWORK**

SYSTEM UND VERFAHREN ZUM ORTEN VON  LEITUNGSSTÖRUNGEN IN EINEM
MITTELSPANNUNGSNETZ

SYSTÈME ET PROCÉDÉ DE LOCALISATION DE DÉFAUTS DE LIGNE DANS UN RÉSEAU
MOYENNE TENSION

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **16.04.2008  IE 20080283**

(43) Date of publication of application:
**16.02.2011   Bulletin 2011/07**

(73) Proprietor: **Fmc Tech Limited
County Clare (IE)**

(72) Inventors:
• **O'SULLIVAN, Charles Brendan
County Limerick (IE)**

• **MCCORMACK, Michael Anthony
County Clare (IE)**

(74) Representative: **Fischer, Michael Maria et al
General Electric Technology GmbH
GE Corporate Intellectual Property
Brown Boveri Strasse 7
5400 Baden (CH)**

(56) References cited:
**WO-A-2004/068151      WO-A-2005/119277
US-A1- 2005 040 809     US-B1- 6 420 876
US-B2- 6 917 888**

**Description**

**Introduction**

This invention relates to a system and method for locating line faults in a medium voltage network. One of the most important aspects of maintaining a medium voltage network is the ability to locate and repair line faults in as short a time as possible. The faster a line fault can be located and repaired, the less inconvenience is caused to the customer. Another advantage of locating and repairing line faults quickly is that the cost of maintaining the network will be reduced, due to the fact that the repair crew will have to spend less time locating the faults, resulting in a reduction in the labour costs. In addition to the reduction in labour costs, the entity maintaining the network will attract lower fines for power outages if such a regime is in place where the medium voltage network is located.

Various methods and systems have been proposed for accurately sensing and locating the position of line faults in medium voltage networks. The applicants own published PCT Patent Application Nos. WO2004/068151, WO2005/119277 and WO2007/135162 each describe systems and methods for detection and location of line faults in medium voltage networks.

WO2004/068151 describes a unique construction of measurement sensor comprising a triplet of measurement sensors that are able to accurately monitor the properties of the power lines as well as a system and method of accurately detecting faults and locating those faults.

WO 2005/119277 discloses a method of determining the likely location of a fault. This is achieved in part by accurate synchronisation of the sensors. The open delta voltage information is sent to each of the remote sensors and the location of faults is determined using the phase of the open delta voltage and the phase of the out-of-balance current, $I_b$.

WO 2007/135162 describes a method and system for detection of faults on a medium voltage network. In the embodiments described, the specification uses an impedance profile of the line, as well as the actual impedance monitored using conducted communication signals to determine the likely location of the fault. An adaptive filter is further employed to determine the location of the fault and the variable coefficients of the adaptive filter are monitored and used to determine, with a reasonable degree of accuracy, the location of the fault on the medium voltage line.

Although highly effective in operation, there are situations in which the performance of the methods and systems described in WO2004/068151, WO2005/119277 and WO2007/135162 could be improved upon. Both WO2004/068151 and WO2005/119277 predominantly relate to methods of detecting and locating faults on networks that incorporate a high impedance grounding methodology, for example those networks that use a Petersen coil. The basic fault location resolution is effectively the same as the number of segments of line between measurement sensors. Neither of these specifications proposes a method of accurately locating a fault location between sensors along the segment, or in other words, a measure of the distance to fault location from each of the sensing points. WO2007/135162 requires the launching of a signal onto the electrical power line. This requires additional circuitry thereby increasing the cost of the sensor and furthermore this requires energy to launch the signal on the line. The energy would have to be derived from a power current transformer which in turn would add to the weight of the sensor.

In addition to the above, various methods have been described for detecting faults on transmission lines, as opposed to medium voltage network power lines. One such method is that described in the paper entitled "Transmission Line Fault Detection and Phase Selection Using ANN" in the names of M. Sanaye-Pasand and H. Khorashadi-Zadeh, disclosed at the International Conference on Power Systems Transients, IPST 2003 in New Orleans, USA. The paper discloses a methodology for determining line faults in a single length of transmission line. The method was modelled on a single simulated line without any branches.

Another paper that describes a method and system for detecting faults on transmission lines is entitled "Fault Location in EHV Transmission Lines Using Artificial Neural Networks" in the name of Tahar Bouthiba, published in International Journal of Applied Mathematics and Computer Science 2004, Volume 14, No. 1, pages 69-78. This paper describes a method for detecting faults in a transmission line, rather than a medium voltage overhead line. This paper further describes a methodology in which a transmission line is modelled and then a number of experimental simulations are carried out on the modelled line to determine the accuracy of various neural networks in detecting fault locations.

Both of the above papers describe the use of artificial neural networks for detection of faults, however, both papers describe their use on transmission lines without any branches. The methods outlined in the two papers would not be suitable for use in a medium voltage network. This is due to the fact that the medium voltage distribution network is significantly more complicated that the transmission network. The known methods estimate the distance from the substation to the fault by measuring the resistance of the cable and from this it is possible to determine the length of conductor to the fault from the substation. In a complex medium voltage distribution network with a tree structure, a substation based relay will not know which "direction" the fault current travelled. For example, the substation relay will not know whether the fault current travelled along the spine or whether the fault current travelled along one of a number of branches before travelling along the spine. Therefore, in a medium voltage network, the measurement of the system impedance to fault (resistance of power line to fault) could give solutions that give a significant number of potential fault locations along the tree structure of power lines that could be spread over a large area. This is of much less practical use than a uniquely defined location and would not significantly aid in the detection of faults in an expeditious manner.

Furthermore, travelling wave methods (similar to the method described in WO2007/135162) can help overcome some of the limitations with the known methods but are relatively complex to implement and changes in the network configuration will change the interpretation of received signals.

It is an object of the present invention to provide a system and method for locating line faults in a medium voltage network that overcomes at least some of the problems with the known systems and methods and that can accurately detect and locate the position of a line fault on a medium voltage line having a plurality of branches.

## Statements of Invention

According to the invention, there is provided a system for locating line faults in a medium voltage network, the medium voltage network comprising a substation and a plurality of electricity carrying power lines extending outwardly therefrom, the power lines being arranged in a tree configuration having a central spine and a plurality of branches splitting off from the central spine at spine breakpoints; the system comprising a plurality of line mounted sensors distributed on the power lines monitoring an electrical property of the power line on which they are mounted, and a fault locating unit in communication with each of the line mounted sensors, the fault locating unit having a processor to analyse data received from the line mounted sensors; characterised in that:

at each of the spine breakpoints there are provided a pair of line mounted sensors mounted on the spine at the spine breakpoint, one of which is upstream of the spine breakpoint, the other of which is downstream of the spine breakpoint.

By having such a system, it will be possible to accurately locate the position of faults on the medium voltage overhead lines. This is due to the fact that there is a sensor upstream and downstream of each branch point. If the fault is in the medium voltage overhead line along one of the branch points, it is possible to accurately determine whether it is along the branch or if it is along the main limb. Heretofore, this has not been possible. The positioning of the sensors in the network essentially "simplifies" the network. Distribution networks tend to follow land usage and settlement and tend to be highly branched. In addition, networks tend to be re-configurable and sections can be fed from more than one substation through the appropriate use of switches. The present invention provides an effective way to determine the location of faults in a branched medium voltage network. In many instances, the location will be unique and this significantly facilitates location of the fault.

In one embodiment of the invention there is provided a system in which the pairs of line mounted sensors are mounted on the spine immediately adjacent to the spine breakpoint.

In another embodiment of the invention there is provided a system in which at least one of the branches has a limb splitting off therefrom at a branch breakpoint, and in which there are provided a pair of line mounted sensors mounted on the branch at the branch breakpoint, one of which is upstream of the branch breakpoint, the other of which is downstream of the branch breakpoint.

In a further embodiment of the invention there is provided a system in which the pair of line mounted sensors mounted on the branch are mounted on the branch immediately adjacent to the branch breakpoint.

In one embodiment of the invention there is provided a system in which the line mounted sensors each comprise a current sensor to measure the line current. In another embodiment of the invention there is provided a system in which the line mounted sensors each comprise a voltage sensor to measure the line voltage.

In a further embodiment of the invention there is provided a system in which there is further provided a substation sensor monitoring an electrical property of the medium voltage network at the substation and in which the fault locating unit is in communication with the substation sensor.

In one embodiment of the invention there is provided a system in which the substation sensor comprises an open delta voltage sensor.

In another embodiment of the invention there is provided a system in which the processor further comprises an artificial neural network (ANN). The use of ANN is seen as particularly useful in obviating the problems posed by branching in the medium voltage network. With the known systems and methods, it is possible that the methods will identify a fault and state that the location of the fault is potentially in a number of different locations spread over a large area. By using the ANN, the ANN enables the identification of patterns in complex data through the use of training, system modelling and iterative methods. For example, fault reports can be used to tune the system on an ongoing basis thereby increasing the accuracy of the ANN in detecting faults. It is envisaged that a set of data will be presented to the ANN along with the expected outcomes. The ANN will then be tuned to give outputs that are the best fit (optimised cost function) to the expected values. The expectation is then that the ANN will make useful predictions of the required output, in this case, distance.

In a further embodiment of the invention there is provided a system in which the ANN has a plurality of inputs, the inputs of the ANN comprising the data of the line mounted sensors. In one embodiment of the invention there is provided a system in which one of the inputs of the ANN further comprises an input from an open delta voltage substation sensor.

In another embodiment of the invention there is provided a system in which each line mounted sensor further comprises a triplet of measurement units, each measurement unit being mounted on a different phase of the power line with respect to the other measurement units.

In a further embodiment of the invention there is provided a system in which each line mounted sensor has a controller associated and in communication therewith, the line mounted sensor communicating with the fault locating unit through the controller associated therewith.

In one embodiment of the invention there is provided a system in which there is provided a single controller at each breakpoint, the single controller being associated and in communication with both of the line mounted sensors immediately adjacent to the breakpoint.

In another embodiment of the invention there is provided a system in which each sensor provides phase-coherent multiple cycle samples to the fault locating unit for analysis. In a further embodiment of the invention there is provided a system in which there is no line mounted sensor on the spine downstream of the spine breakpoint most remote from the substation.

In one embodiment of the invention there is provided a method of locating line faults in a medium voltage network, the medium voltage network comprising a substation and a plurality of electricity carrying power lines extending outwardly therefrom, the power lines being arranged in a tree configuration having a central spine and a plurality of branches splitting off from the central spine at spine breakpoints; the system comprising a plurality of line mounted sensors distributed on the power lines monitoring an electrical property of the power line on which they are mounted, and a fault locating unit in communication with each of the line mounted sensors, the fault locating unit having a processor to analyse data received from the line mounted sensors, the method comprising the steps of:

(a) at each spine breakpoint monitoring the electrical property of the power line upstream of the spine breakpoint and transmitting the monitored electrical property from upstream of the spine breakpoint to the fault locating unit;

(b) at each spine breakpoint monitoring the electrical property of the power line downstream of the spine breakpoint and transmitting the monitored electrical property from downstream of the spine breakpoint to the fault locating unit;

(c) the fault locating unit analysing the monitored electrical property received from the line mounted sensors and determining whether there is a fault on the medium voltage network; and

(d) on determining that there is a fault in the medium voltage network, the fault locating unit determining the location of the fault on the medium voltage network.

In another embodiment of the invention there is provided a method in which the method comprises monitoring the electrical property of the power line immediately adjacent to the spine breakpoint.

In a further embodiment of the invention there is provided a method in which at least one of the branches has a limb splitting off therefrom at a branch breakpoint, and in which the method further comprises the steps of:

(e) at each branch breakpoint monitoring the electrical property of the power line upstream of the branch breakpoint and transmitting the monitored electrical property from upstream of the branch breakpoint to the fault locating unit; and

(f) at each branch breakpoint monitoring the electrical property of the power line downstream of the branch breakpoint and transmitting the monitored electrical property from downstream of the branch breakpoint to the fault locating unit.

In one embodiment of the invention there is provided a method in which the method comprises monitoring the electrical property of the power line immediately adjacent to the branch breakpoint.

In another embodiment of the invention there is provided a method in which the step of analysing the monitored electrical property received from the line mounted sensors further comprises the fault locating unit comparing the monitored electrical property of each line mounted sensor with the monitored electrical property of at least one adjacent line mounted sensor.

In a further embodiment of the invention there is provided a method in which the step of determining whether there is a fault on the medium voltage network comprises determining whether there is a change in the difference between the monitored electrical property of a line mounted sensor and an adjacent line mounted sensor above a predetermined threshold.

In one embodiment of the invention there is provided a method in which the step of determining the location of the fault comprises the initial step of determining whether the fault is on the branch or on the spine.

In another embodiment of the invention there is provided a method in which on determining that the fault is on the branch, the step of determining the location of the fault further comprises the subsequent step of determining the distance of the fault from the line mounted sensor located upstream of the spine breakpoint.

In a further embodiment of the invention there is provided a method in which on determining that the fault is on the spine, the step of determining the location of the fault further comprises the subsequent step of determining the distance of the fault from the line mounted sensor located downstream of the spine breakpoint.

In one embodiment of the invention there is provided a method in which the steps of the fault locating unit analysing the monitored electrical property received from the line mounted sensors, determining whether there is a fault on the medium voltage network and determining the location of the fault on the medium voltage network comprises the step of passing the monitored electrical property data of each of the sensors to an artificial neural network.

In another embodiment of the invention there is provided a method in which the line mounted sensors each measure the line current.

In a further embodiment of the invention there is provided a method in which the line mounted sensors each measure the line voltage.

In one embodiment of the invention there is provided a method in which the medium voltage network further comprises a substation sensor which measures the substation open delta voltage and transmits the open delta voltage to the fault locating unit.

In another embodiment of the invention there is provided a method in which each line mounted sensor has a controller associated and in communication therewith, the line mounted sensor communicating with the fault locating unit through the controller associated therewith.

In a further embodiment of the invention there is provided a method in which there is provided a single controller at each spine or branch breakpoint, the single controller being associated and in communication with both of the line mounted sensors immediately adjacent to the breakpoint and both of those line mounted sensors communicate with the fault locating unit through the controller associated therewith.

In one embodiment of the invention there is provided a method in which each sensor provides phase-coherent multiple cycle samples to the fault locating unit for analysis.

## Detailed Description of the Invention

The invention will now be more clearly understood from the following description of some embodiments thereof, given by way of example only, with reference to the accompanying drawings, in which:

Fig. 1 is a diagrammatic representation of a system for locating line faults in a medium voltage network known in the art;

Fig. 2 is a diagrammatic representation of a system for locating line faults in a medium voltage network according to the present invention;

Fig. 3 is a diagrammatic representation of an another system for locating line faults in a medium voltage network according to the present invention;

Fig. 4 is a diagrammatic representation of a further system for locating line faults in a medium voltage network according to the present invention; and

Fig. 5 shows the current and voltage waveforms for the three phases of the medium voltage network in which a phase-to-phase fault is experienced.

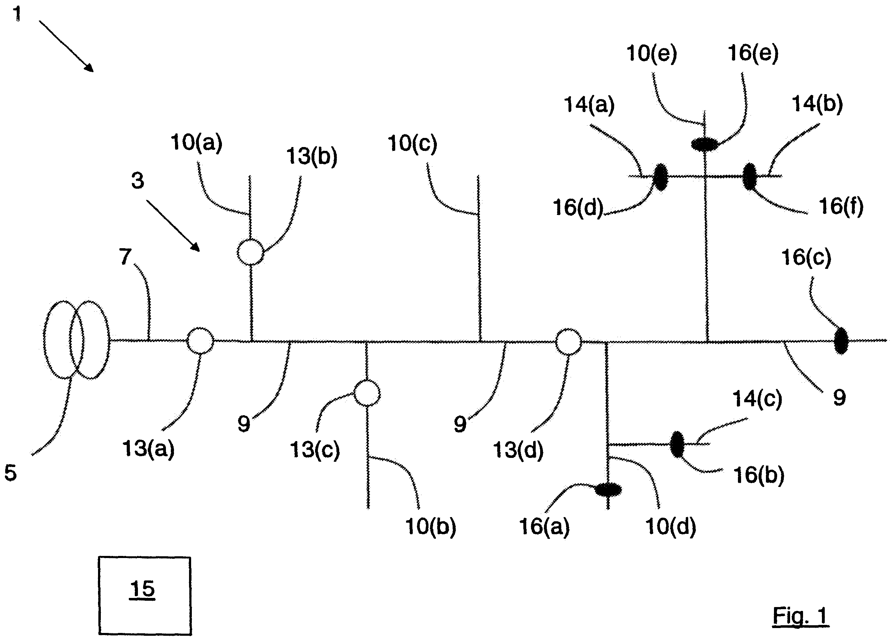

Referring to Fig. 1, there is shown a system that is known in the art, indicated generally by the reference numeral 1, for locating line faults in a medium voltage network, indicated generally by the reference numeral 3. The medium voltage network 3 comprises a substation transformer 5 and a plurality of electricity carrying power lines 7 arranged in a tree configuration having a central spine 9 and a plurality of branches 10(a) -10(e) splitting off from the central spine at what are commonly referred to as spine breakpoints 11(a) - 11(e). A plurality of line mounted sensors 13(a) - 13(d) are mounted on the medium voltage power lines 7. A fault location unit 15 is in communication with the line mounted sensors 13(a) - 13(d).

In use, if there is a fault on one of the branches 10(a) - 10(e) or on the central spine 9, one or more of the sensors 13(a) - 13(d) will detect the presence of the fault and will send a message to the fault locating unit 15 that there is a fault on the line registered by that sensor. In the case of the sensor 13(d), if the sensor 13(d) detects a fault, the fault could be anywhere downstream of that sensor 13(d). The fault could be on the central spine 9, the branch 10(d), the branch 10(e) or on any of the limbs 14(a), 14(b) or 14(c). The portion of the spine 9, the branches 10(d), 10(e) and limbs 14(a), 14(b) and 14(c) could cover a length of medium voltage overhead power line of the order of 50Km in length and it is difficult to quickly locate the fault in such a case. For example, the known systems and methods would indicate that the distance to the fault is 50km from the substation but this could be in any of the fault locations 16(a) - 16(f), all of which are 50km from the substation 13(d). This causes significant difficulty.

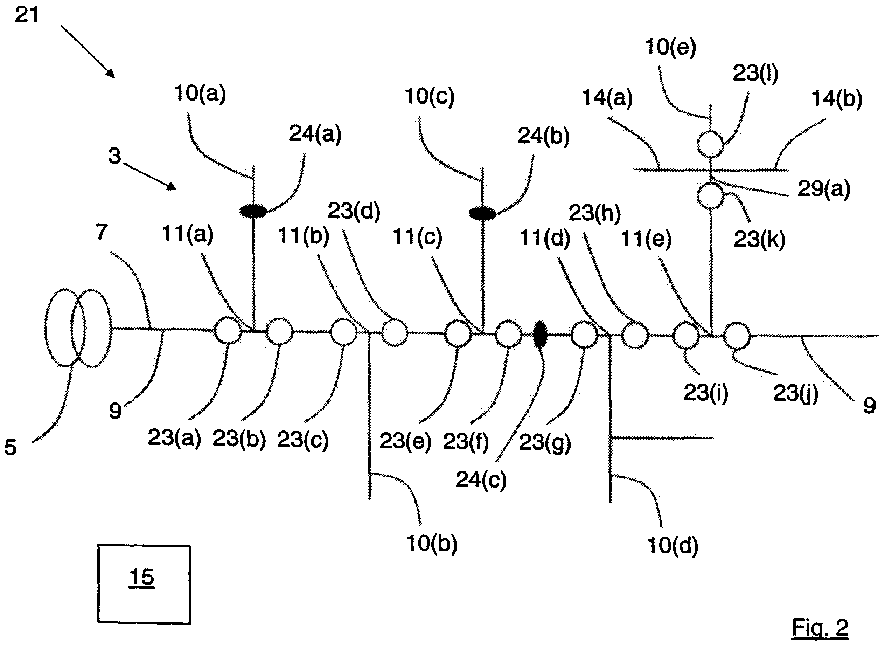

Referring to Fig. 2, there is shown a system according to the present invention, indicated generally by the reference numeral 21, where like parts have been given the same reference numerals as before. The system 21 comprises a plurality of line mounted sensors 23(a) - 23(l) mounted on the lines. In the system 21, there are provided a pair of the line mounted sensors 23(a) - 23(l) mounted adjacent each spine breakpoint 11(a) to 11(e). The line mounted sensors 23(a), 23(b) are mounted on the spine 9 immediately adjacent to the spine breakpoint 11(a). The line mounted sensor 23(a) is immediately adjacent to the spine breakpoint 11(a) and is upstream of the spine breakpoint 11(a) and the line mounted sensor 23(b) is immediately adjacent to the spine breakpoint 11(a) and is downstream of the spine breakpoint 11(a). The sensors 23(k) and 23(l) are either side of a branch breakpoint 29(a) where two limbs 14(a) and 14(b) split out from the branch at the branch breakpoint 29(a). Each of the line mounted sensors 23(a) - 23(l) measures the current in the line.

In use, if a fault occurs on the medium voltage network, the sensors will be able to locate the fault more accurately than was heretofore the case. In the preferred embodiment, each of the line mounted sensors comprises a current sensor and monitors the line current of the line on which it is mounted. In three phase systems, a triplet of measurement units each having a current sensor will be provided, one on each phase of the line. If a fault occurs at location 24(a) on the branch 10(a), the sensor 23(a) will detect an increase in current whereas the remaining sensors downstream of the branch breakpoint 11(a) will detect a decrease in current. The measurements of current from each of the sensors will be monitored by the fault location unit 15 which will detect the change in current between sensors 23(a) and 23(b). As the current in 23(b) reduced, it will be quickly ascertained by the fault location unit 15 that the fault is along the branch 10(a), otherwise referred to as a spur or lateral.

If a fault occurs at location 24(b) on the branch 10(c), the sensors 23(a) to 23(e) will detect an increase in current whereas the remaining sensors downstream of the branch breakpoint 11(c) will detect a decrease in current. The measurements of current from each of the sensors will be monitored by the fault location unit 15 which will detect the change in current between sensors 23(e) and 23(f). As the current in 23(f) reduced, it will be quickly ascertained by the fault location unit 15 that the fault is along the branch 10(c).

If a fault occurs at location 24(c) on the spine 9, the sensors 23(a) to 23(f) will detect an increase in current whereas the remaining sensors 23(g) - 23(l) downstream of the fault 24(c) will detect a decrease in current. The measurements of current from each of the sensors will be monitored by the fault location unit 15 which will detect the change in current between sensors 23(f) and 23(g). As the current in 23(g) reduced, it will be quickly ascertained by the fault location unit 15 that the fault is along the spine 9 between the sensors 23(f) and 23(g).

Once the general location of the fault is known, for example on a branch or on the spine, the precise location of the fault may be determined by calculating the distance from the sensor to the fault location. In order to calculate the distance to the fault location, the sensed current value is used in conjunction with a voltage value for the line to calculate the impedance of the line. The impedance is proportional to the length of the line to the line fault and therefore may be used to determine the location of the fault.

In order to more clearly describe the manner in which the current can be used to determine the distance to the fault, the following illustrative example is provided and the values have been selected for convenience only and are not intended to be indicative of actual values on the line. Using Ohms law equation:

$$I = V/Z$$

And rewriting it as:

$$Z = V/I$$

If we say that the current under steady state conditions at sensor 23(a) is usually 50A and the voltage is 200V (the voltage may either be an arbitrarily chosen value or a measured value), then the impedance of the branch 10(a) is 4Ω (Ohms) (Z=200/50). It should be recognised that the line impedance is complex (resistive, inductive capacitive). The inductive component predominates. For the "Linet" conductor for example, the line impedance might be 0.3619 Ohms (resistive) per mile and j1.0638 Ohms/ Mile (reactive). In this example, for simplicity we are using the magnitude of the impedance only for illustrative purposes.

If we know that the branch 10(a) is 10km long then we also know that for a uniform conductor, each kilometre will have an impedance of 0.4Ω. If a fault should then occur on the line and the current in the sensor 23(a) increases to 100A, the impedance will have reduced to 2Ω (R=200/100). If each kilometre equates to 0.4Ω in impedance, then 2Ω must equate to 5km (2 $\Omega$/0.4 $\Omega$). The fault is then calculated to be on the branch 5 km from the sensor 23(a). Similarly, if the current should increase to 400A, then the impedance would be 0.5 $\Omega$ (R=200/400) and the fault would be calculated to be 1.25km (0.5 $\Omega$ / 0.4 $\Omega$) away from the sensor 23(a).

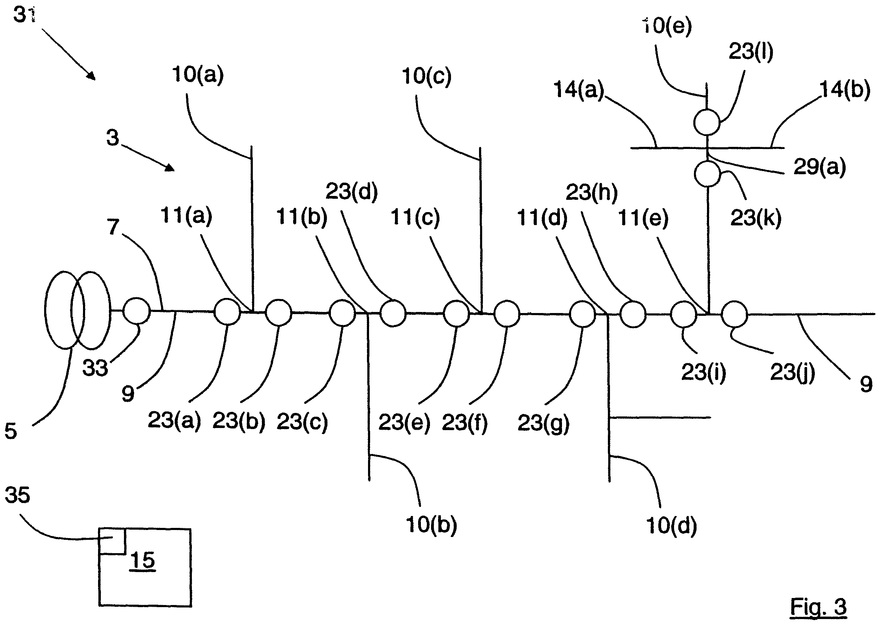

Referring to Figure 3, there is shown a system according to the present invention, indicated generally by the reference numeral 31, where like parts have been given the same reference numerals as before. The system 31 further comprises a sensor 33 in the substation measuring the open delta voltage. The open delta voltage is typically available in high impedance grounded systems. The voltages of all phases may also be measured by providing voltage sensors in each of the line mounted sensors. In the embodiment shown, the fault locating unit 15 further comprises an artificial neural network (ANN) 35 capable of receiving the current measurements from the sensors 23(a) - 23(l) as well as the voltage measurement from the sensors 23(a) - 23(l) if available and the voltage measurement from the substation sensor 43.

In use, the current values sensed by each of the sensors will be used as inputs to the ANN 35 and the ANN will be used to detect the presence and location of faults on the medium voltage network. Appropriate training of the ANN will be necessary to create a library of fault conditions that it can refer to when determining whether there is a fault or not and if there is a fault, where the fault is.

If voltage sensors are provided and the line voltage at the sensors is known, it is possible to get a better measure of resistance and the method is less dependent on knowledge of feed voltage or transformer impedance. Knowledge of both line voltage and line current will enhance the systems performance. There are however cost implications as additional voltage sensors would need to be provided to the line mounted sensor units remote from the substation. Alternatively or in addition to the line voltage information, voltage information is normally available relatively conveniently in the substation. Furthermore, the sensors downstream of a fault can provide some indication of line voltage, assuming that the load does not change too dramatically. The current measured on the downstream sensors will be a function of line voltage and therefore it is possible to estimate the line voltage if the line current is known.

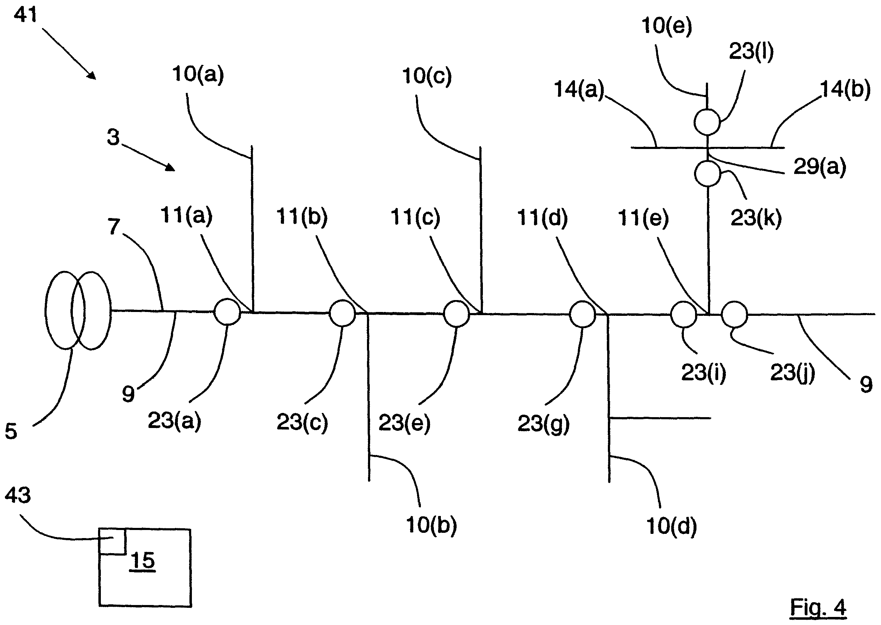

Referring to Fig. 4, there is shown a system according to the present invention, indicated generally by the reference numeral 41, where like parts have been given the same reference numerals as before. The system 41 comprises a plurality of line mounted sensors 23(a), 23(c), 23(e), 23(g), 23(i), 23(j), 23(k) and 23(l) with one sensor mounted on the upstream side of each breakpoint 11(a) - 11(e) and another sensor mounted on the downstream side of each spine breakpoint. Effectively, the number of sensors has been reduced by not having the sensors located immediately adjacent to the breakpoints. It is envisaged that such a system may provide adequate performance in a low impedance (high current) medium voltage network but would probably not be utilised in a high impedance (low current) medium voltage network. The fault location unit 15 comprises a processor 43 for processing data from the sensors and this may be a processor having means to calculate the fault location from the current data and voltage data if provided by either the sensors 23(a) - 23(l) or from a substation sensor (not shown).

It is envisaged that in the embodiments described above in Figures 2 to 4, each measurement sensor 23(a) - 23(l) will comprise a triplet of measurement units, each of the measurement units being mounted on a different phase of the power line with respect to the other measurement units. Furthermore, it is envisaged that each line mounted sensor 23(a) - 23(l) will have a controller (not shown) associated therewith. The controller will be in communication with the line mounted sensor and the fault locating unit 15 and the line mounted sensors 23(a) - 23(l) will therefore communicate with the fault locating unit 15 through the controller. Preferably, the controller will be pole mounted.

Due to the fact that two line mounted sensors are mounted immediately adjacent to each breakpoint 11(a) - 11(e), 29(a) - 29(b), in Figures 2 and 3, a single controller may be used mounted adjacent the spine or branch breakpoint and be in communication with a pair of the line mounted sensors. In this way, a reduced number of controllers may be provided which has economic benefits. By immediately adjacent, what is meant is that the line mounted sensors will be mounted no further than two hundred metres from a breakpoint. Furthermore, the medium voltage power lines are preferably overhead power lines in which case it is envisaged that it will be possible to accurately monitor faults. However, it is further envisaged that some of the power lines may be sub-terranean power lines and the invention would still have applications in that field.

Each of the line mounted sensors provides phase-coherent multiple cycle samples to the fault locating unit for processing and analysis so that an accurate real time evaluation of the state of the network and the location of the faults may be carried out. It is envisaged that the present invention will be particularly useful at detecting low impedance ground faults, as well as phase-to-phase faults. This is due to the fact that both phase-to-phase and ground faults will generate relatively high currents, typically of the order of 100A for faults remote from the substation to 2,000A for faults close to the substation. The levels of current are closely related to line length and this simplifies the estimation of the distance to fault.

Furthermore, it may be possible to detect high impedance faults with some minor modification to the systems described above. For example, it may be possible to detect single ground faults on high impedance systems (for example systems using high impedance ground treatment such as a Petersen coil or "ungrounded" delta systems). Phase-to-phase and cross-country faults are similar on both low impedance and high impedance systems. In order to allow the method and system detect high impedance faults, some modifications may have to be made to the ANN so that it is trained appropriately to detect these faults and also that it is equipped to receive all necessary inputs.

For example, typically, the Petersen coil inductance is adjusted to balance the capacitive component of the ground fault in a single fault scenario. The net current is limited which has the net effect of extinguishing arcs at the faulted location. This will need to be modelled before specific values can be established that can be used with the ANN. The resistor that is typically parallel to the Petersen coil dampens the transient condition that arise when the star point (Y wound feed) moves from a close to ground potential to a phase potential on application of a ground fault. A distance to ground fault solution (for high impedance systems) can be based on measuring the transient current that arises on application of a fault. The shape of the damped sinusoid will give useful information. This information can be used to assist in the detection of faults and can be used in conjunction with the ANN.

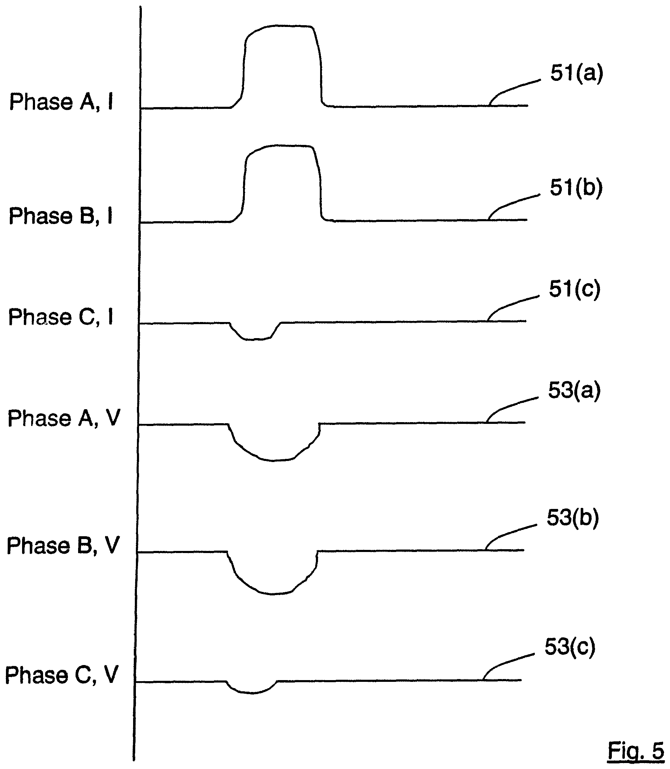

Referring to Figure 5 of the drawings, there is shown the current 51(a) - 51(c) and voltage waveforms 53(a) - 53(c) for the three phases, A, B and C, of the medium voltage network in which a phase-to-phase fault is experienced. In this instance, there is a phase A to phase B fault. It can be seen from the waveforms that there is significant change to the currents in the first two phases and a minor disturbance in the third phase. Similarly, there is a corresponding significant change in the voltage of the first two phases with a smaller disturbance on the third phase. A number of samples are taken over the current waveforms 51(a), 51(b) and 51(c). The corresponding voltage waveforms 53(a), 53(b), 3(c) for each of the phases A, B and C, also show minor disturbances and from these phase current and voltage waveforms, it is possible to accurately predict the time of the fault.

Once the time of the fault is known, then it is possible to accurately locate the position of the fault on the line. This is achieved using the following analysis: The current is dependent on voltage and resistance (fault, feeder and line). I=V/Z or I = f(V,Zline), where Zline is the line impedance. The line impedance is dependent on line length, temperature and conductor type. So we can say Zline = g(I,V,T, feeder impedance, fault resistance). The line impedance per unit distance is defined for a given conductor type. This is sometimes referred to a the "phase impedance matrix". If a line experiences a "short circuit" fault then the current flowing on the line will be controlled by the line impedance. The line impedance is a function of line length (distance from feed point to fault location). The fault current is a function of line length. The longer the line the lower the fault current. (It is also dependent on the feeder transformer impedance which is where a measure of feeder voltages simplifies matters - this impedance can be measured or modelled which allows us to use a "current only" approach where this is advantageous). The approach as outlined in this description is applicable to one, two and three phase systems through the use of the appropriate impedance matrix.

Accordingly, the distance to fault is a function 'h', Distance = h(I,V,T, feeder impedance, fault resistance). This can be solved analytically. Alternatively, ANN methods may be used to determine the fault location. The distance to fault may be expressed as a function of the upstream sensor currents and the downstream sensor currents:

$$DistanceToFault=func(Ia1,Ib1,Ic1, Ia2,Ib2,Ic2)$$

An ANN is an effective way of resolving the function where the Ia1, Ib1, Ic1, Ia2, Ib2 and Ic2 are presented as a set of samples. In addition to the above, it is possible to express the distance to fault as a function of both the upstream sensor currents, the downstream sensor currents and the substation voltages as follows:

$$DistanceToFault=func2(Va,Va,Vc,Ia1,Ib1,Ic1,Ia2,Ib2,Ic2),$$

where Va,Vb,Vc, are the phase voltages measured at the substation. It is envisaged that using current readings from more than two sets of sensors may yield improved performance. It is further envisaged that other inputs to the ANN may also improve performance of the neural network.

The sensors provide peak current and can provide bursts of samples which can be used to analyse higher harmonics and not simply the first harmonic. Due to the fact that faults can present highly non-linear loads, this results in a lot of noise and interference. The number of samples taken by the sensors is variable and configurable, although preferably between 5 to 20 cycles depending on the system requirements. Larger numbers of samples may be useful in situations where the fault type may change over a period of time, for example, if a phase-to-ground changes to a phase-to-phase fault over a few seconds. Furthermore, simple mathematical calculations can be used for determining the position of the line faults reducing the complexity of the computations.

This invention applies to both low impedance grounded systems and high impedance grounded systems. The present invention is applicable to low impedance faults such as simple ground faults on low impedance grounded systems, phase to phase faults (short circuits) and cross country faults (a phase to phase fault incorporating the intervening ground). It is envisaged that the general approach will also find application in locating simple ground faults in high impedance systems. For high impedance grounded systems, where line currents are relatively low, it is envisaged that a system in which there are provided line mounted sensors located immediately adjacent each of the breakpoints will be more effective. The invention also applies not only to three phase systems but also to two phase implementations and would work effectively in two phase systems also.

It will be understood that in certain circumstances, there will a change in the relative current values of two adjacent sensors caused by an increase in the load. Accordingly, it may be preferable to have a predetermined threshold, for example 10A, that must be exceeded in order to indicate a fault condition. Alternatively, or as an additional back up to using a predetermined threshold to indicate a fault, it may be advantageous to carry out an examination of the phases of the line current from each measurement unit of the line mounted sensors to see whether there are relatively short changes in one or more of the electrical properties of the line which are indicative of a fault.

In this specification, the terms "comprise", "comprises", "comprised" and "comprising" and the terms "include", "includes", "included" and "including" are deemed totally interchangeable and should be afforded the widest possible interpretation.

This invention is in no way limited to the embodiment hereinbefore described but is only limited by the appended claims.

**Claims**

1. A system (21) for locating line faults in a medium voltage network (3), the medium voltage network comprising a substation and a plurality of electricity carrying power lines (7) extending outwardly therefrom, the power lines being arranged in a tree configuration having a central spine (9) and a plurality of branches (10(a) - 10(e)) splitting off from the central spine at spine breakpoints (11(a) - 11(e)); the system comprising a plurality of line mounted sensors (23(a) - 23(l)) distributed on the power lines monitoring an electrical property of the power line on which they are mounted, and a fault locating unit (15) in communication with each of the line mounted sensors, the fault locating unit having a processor to analyse data received from the line mounted sensors; **characterised in that**:
at each of the spine breakpoints (11(a) - 11(e)) there are provided a pair of line mounted sensors (23(a) - 23(l)) mounted on the spine at the spine breakpoint, one of which is upstream of the spine breakpoint, the other of which is downstream of the spine breakpoint.

2. A system (21) as claimed in claim 1 in which the pairs of line mounted sensors (23(a) - 23(l)) are mounted on the spine immediately adjacent to the spine breakpoint (11(a) - 11(e)).

3. A system (21) as claimed in claim 1 or 2 in which at least one of the branches has a limb (14a, 14b) splitting off therefrom at a branch breakpoint (29(a)), and in which there are provided a pair of line mounted sensors (23(k), 23(l)) mounted on the branch at the branch breakpoint, one of which is upstream of the branch breakpoint, the other of which is downstream of the branch breakpoint.

4. A system (21) as claimed in claim 3 in which the pair of line mounted sensors (23(k), 23(l)) mounted on the branch are mounted on the branch immediately adjacent to the branch breakpoint.

5. A system (21) as claimed in any preceding claim in which the line mounted sensors each comprise a current sensor to measure the line current.

6. A system (21) as claimed in any preceding claim in which the line mounted sensors each comprise a voltage sensor to measure the line voltage.

7. A system (31) as claimed in any preceding claim in which there is further provided a substation sensor (33) monitoring an electrical property of the medium voltage network (3) at the substation and in which the fault locating unit is in communication with the substation sensor.

8. A system (31) as claimed in claim 7 in which the substation sensor comprises an open delta voltage sensor.

9. A system (21, 31) as claimed in any preceding claim, in which each line mounted sensor has a controller associated and in communication therewith, the line mounted sensor communicating with the fault locating unit through the controller associated therewith, and in which there is provided a single controller at each breakpoint, the single controller being associated and in communication with both of the line mounted sensors immediately adjacent to the breakpoint.

10. A system (21, 31) as claimed in any preceding claim, in which each sensor provides phase-coherent multiple cycle samples to the fault locating unit for analysis.

11. A method of locating line faults in a medium voltage network (3), the medium voltage network comprising a substation and a plurality of electricity carrying power lines (7) extending outwardly therefrom, the power lines being arranged in a tree configuration having a central spine (9) and a plurality of branches (10(a) - 10(e)) splitting off from the central spine at spine breakpoints (11(a) - 11(e)); the system comprising a plurality of line mounted sensors (23(a) - 23(l)) distributed on the power lines monitoring an electrical property of the power line on which they are mounted, and a fault locating unit in communication with each of the line mounted sensors, the fault locating unit having a processor to analyse data received from the line mounted sensors, the method comprising the steps of:

(a) at each spine breakpoint (11(a) - 11(e)) monitoring the electrical property of the power line upstream of the spine breakpoint and transmitting the monitored electrical property from upstream of the spine breakpoint to the fault locating unit;
(b) at each spine breakpoint (11(a) - 11(e)) monitoring the electrical property of the power line downstream of the spine breakpoint and transmitting the monitored electrical property from downstream of the spine breakpoint to the fault locating unit;
(c) the fault locating unit analysing the monitored electrical property received from the line mounted sensors and determining whether there is a fault on the medium voltage network; and
(d) on determining that there is a fault in the medium voltage network, the fault locating unit determining the location of the fault on the medium voltage network.

12. A method as claimed in claim 11 in which the method comprises monitoring the electrical property of the power line immediately adjacent to the spine breakpoint (11(a) - 11(e)).

13. A method as claimed in claim 11 or 12 in which at least one of the branches has a limb splitting off therefrom at a branch breakpoint, and in which the method further comprises the steps of:

(e) at each branch breakpoint monitoring the electrical property of the power line upstream of the branch breakpoint and transmitting the monitored electrical property from upstream of the branch breakpoint to the fault locating unit; and
(f) at each branch breakpoint monitoring the electrical property of the power line downstream of the branch breakpoint and transmitting the monitored electrical property from downstream of the branch breakpoint to the fault locating unit.

14. A method as claimed in claim 13 in which the method comprises monitoring the electrical property of the power line (7) immediately adjacent to the branch breakpoint.

15. A method as claimed in claims 11 to 14 in which the step of analysing the monitored electrical property received from the line mounted sensors further comprises the fault locating unit comparing the monitored electrical property of each line mounted sensor with the monitored electrical property of at least one adjacent line mounted sensor.

16. A method as claimed in claim 15 in which the step of determining whether there is a fault on the medium voltage network comprises determining whether there is a change in the difference between the monitored electrical property of a line mounted sensor and an adjacent line mounted sensor above a predetermined threshold.

17. A method as claimed in claims 11 to 16 in which the step of determining the location of the fault comprises the initial step of determining whether the fault is on the branch or on the spine (9), and in which on determining that the fault is on the branch, the step of determining the location of the fault further comprises the subsequent step of determining the distance of the fault from the line mounted sensor located upstream of the spine breakpoint.

18. A method as claimed in claims 11 to 16 in which the step of determining the location of the fault comprises the initial step of determining whether the fault is on the branch or on the spine, and in which on determining that the fault is on the spine (9), the step of determining the location of the fault further comprises the subsequent step of determining the distance of the fault from the line mounted sensor located downstream of the spine breakpoint.

19. A method as claimed in claims 11 to 18 in which the line mounted sensors each measure the line current.

20. A method as claimed in claims 11 to 19 in which the line mounted sensors each measure the line voltage.

21. A method as claimed in claims 11 to 20 in which the medium voltage network further comprises a substation sensor (33) which measures the substation open delta voltage and transmits the open delta voltage to the fault locating unit.

22. A method as claimed in claims 11 to 21 in which each line mounted sensor has a controller associated and in communication therewith, the line mounted sensor communicating with the fault locating unit through the controller associated therewith and in which there is provided a single controller at each spine or branch breakpoint, the single controller being associated and in communication with both of the line mounted sensors immediately adjacent to the breakpoint and both of those line mounted sensors communicate with the fault locating unit through the controller associated therewith.

23. A method as claimed in claims 11 to 22 in which each sensor provides phase-coherent multiple cycle samples to the fault locating unit for analysis.

**Patentansprüche**

1. System (21) zur Ortung von Leitungsfehlern in einem Mittelspannungsnetzwerk (3), wobei das Mittelspannungsnetzwerk ein Umspannwerk und eine Vielzahl von stromführenden Stromleitungen (7) umfasst, die von dort nach außen führen, wobei die Stromleitungen in einer Baumkonfiguration angeordnet sind, die eine zentrale Hauptbahn (9) und eine Vielzahl von Verzweigungen (10(a) - 10(e)) aufweist, die an Unterbrechungspunkten (11(a) - 11(e)) der Hauptbahn von der Hauptbahn abgehen; wobei das System eine Vielzahl von an der Leitung montierten Sensoren (23(a) - 23(l)) auf die Stromleitungen verteilt umfasst, die eine elektrische Eigenschaft der Stromleitung überwachen, auf der sie montiert sind, und eine Fehlerortungseinheit (15) in Kommunikation mit jedem der an der Leitung montierten Sensoren, wobei die Fehlerortungseinheit einen Prozessor aufweist, um Daten zu analysieren, die von den Sensoren empfangen werden, die auf der Leitung montiert sind; **dadurch gekennzeichnet, dass**:
an jedem der Unterbrechungspunkte (11(a) - 11(e)) der Hauptbahn ein Paar von an der Leitung montierten Sensoren (23(a) - 23(l)) bereitgestellt ist, das am Unterbrechungspunkt der Hauptbahn auf der Hauptbahn montiert ist, von denen sich eines vorgelagert vom Unterbrechungspunkt der Hauptbahn befindet, sich das andere davon nachgelagert vom Unterbrechungspunkt der Hauptbahn befindet.

2. System (21) nach Anspruch 1 wobei die Paare von an den Leitungen montierten Sensoren (23(a) - 23(l)) an der Hauptbahn unmittelbar neben dem Unterbrechungspunkt der Hauptbahn (11(a) - 11(e)) montiert sind.

3. System (21) nach Anspruch 1 oder 2 wobei mindestens eine der Verzweigungen einen Ast (14a, 14b) aufweist, der von dort an einem Unterbrechungspunkt der Verzweigung (29(a)) abgeht und in dem ein Paar von an der Leitung montierten Sensoren (23(k), 23(l)) bereitgestellt ist, das an der Verzweigung am Unterbrechungspunkt der Verzweigung montiert ist, von denen sich einer vorgelagert vom Unterbrechungspunkt der Verzweigung befindet, sich der andere davon nachgelagert vom Unterbrechungspunkt der Verzweigung befindet.

4. System (21) nach Anspruch 3, wobei das Paar von an der Leitung montierten Sensoren (23(k), 23(1)), die an der Verzweigung montiert sind, unmittelbar neben dem Unterbrechungspunkt der Verzweigung an der der Verzweigung montiert ist.

5. System (21) nach einem der vorstehenden Ansprüche, wobei die an der Leitung montierten Sensoren jeweils einen Stromsensor umfassen, um den Leitungsstrom zu messen.

6. System (21) nach einem der vorstehenden Ansprüche, wobei die an der Leitung montierten Sensoren jeweils einen Spannungssensor umfassen, um die Leitungsspannung zu messen.

7. System (31) nach einem der vorstehenden Ansprüche, wobei weiter ein Umspannwerksensor (33) bereitgestellt ist, der eine elektrische Eigenschaft des Mittelspannungsnetzwerks (3) am Umspannwerk überwacht und in dem die Fehlerortungseinheit in Kommunikation mit dem Umspannwerksensor ist.

8. System (31) nach Anspruch 7, wobei der Umspannwerksensor einen offenen Dreieckspannungssensor umfasst.

9. System (21, 31) nach einem der vorstehenden Ansprüche, wobei jeder an der Leitung montierte Sensor einen zugeordneten und damit in Kommunikation stehenden Regler aufweist, wobei der an der Leitung montierte Sensor mit der Fehlerortungseinheit durch den damit zugeordneten Regler kommuniziert, und in dem ein einzelner Regler an jedem Unterbrechungspunkt bereitgestellt ist, wobei der einzelne Regler beiden an der Leitung montierten Sensoren unmittelbar neben dem Unterbrechungspunkt zugeordnet ist und damit in Kommunikation steht.

10. System (21, 31) nach einem der vorstehenden Ansprüche, wobei jeder Sensor der Fehlerortungseinheit phasenkohärente Proben mit mehreren Zyklen zur Analyse bereitstellt.

11. Verfahren zur Ortung von Leitungsfehlern in einem Mittelspannungsnetzwerk (3), wobei das Mittelspannungsnetzwerk ein Umspannwerk und eine Vielzahl von stromführenden Stromleitungen (7) umfasst, die von dort nach außen führen, wobei die Stromleitungen in einer Baumkonfiguration angeordnet sind, die eine zentrale Hauptbahn (9) und eine Vielzahl von Verzweigungen (10(a) - 10(e)) aufweist, die an Unterbrechungspunkten (11(a) - 11(e)) der Hauptbahn von der Hauptbahn abgehen; wobei das System eine Vielzahl von an der Leitung montierten Sensoren (23(a) - 23(l)) auf die Stromleitungen verteilt umfasst, die eine elektrische Eigenschaft der Stromleitung überwachen, auf denen sie befestigt sind, und eine Fehlerortungseinheit in Kommunikation mit jedem der an der Leitung montierten Sensoren, wobei die Fehlerortungseinheit einen Prozessor aufweist, um Daten zu analysieren, die von den an der Leitung montierten Sensoren empfangen werden, wobei das Verfahren die folgenden Schritte umfasst:

(a) an jedem Unterbrechungspunkt der Hauptbahn (11(a) - 11(e)) Überwachen der elektrischen Eigenschaft der Stromleitung, die sich vorgelagert vom Unterbrechungspunkt der Hauptbahn befindet und die Übermittlung der überwachten elektrischen Eigenschaft vorgelagert von dem Unterbrechungspunkt der Hauptbahn zur Fehlerortungseinheit;

(b) an jedem Unterbrechungspunkt der Hauptbahn (11(a) - 11(e)) Überwachen der elektrischen Eigenschaft, die sich nachgelagert vom Unterbrechungspunkt der Hauptbahn befindet und die Übermittlung der elektrischen Eigenschaft nachgelagert von dem Unterbrechungspunkt der Hauptbahn zur Fehlerortungseinheit;

(c) Analysieren der überwachten elektrischen Eigenschaft, die von den an der Leitung montierten Sensoren empfangen wird durch die Fehlerortungseinheit, und Bestimmen, ob ein Fehler in dem Mittelspannungsnetzwerk vorliegt; und

(d) bei der Bestimmung, dass ein Fehler im Mittelspannungsnetzwerk vorliegt, die Bestimmung durch die Fehlerortungseinheit des Ortes des Fehlers in dem Mittelspannugsnetzwerk.

12. Verfahren nach Anspruch 11, wobei das Verfahren die Überwachung der elektrischen Eigenschaft der Stromleitung unmittelbar neben dem Unterbrechungspunkt der Hauptbahn (11(a) - 11(e)) umfasst.

13. Verfahren nach Anspruch 11 oder 12, wobei mindestens eine der Verzweigungen einen Ast aufweist, der von dort an einem Unterbrechungspunkt der Verzweigung abgeht und wobei das Verfahren weiter die folgenden Schritte umfasst:

(e) an jedem Unterbrechungspunkt der Verzweigung die Überwachung der elektrischen Eigenschaft der Stromleitung vorgelagert vom Unterbrechungspunkt der Verzweigung und die Übermittlung der überwachten elektrischen Eigenschaft vorgelagert vom Unterbrechungspunkt der Verzweigung zur Fehlerortungseinheit; und

(f) an jedem Unterbrechungspunkt der Verzweigung die Überwachung der elektrischen Eigenschaft der Stromleitung nachgelagert vom Unterbrechungspunkt der Verzweigung und die Übermittlung der überwachten elektrischen Eigenschaft nachgelagert vom Unterbrechungspunkt der Verzweigung zur Fehlerortungseinheit.

14. Verfahren nach Anspruch 13, wobei das Verfahren die Überwachung der elektrischen Eigenschaft der Stromleitung (7) unmittelbar neben dem Unterbrechungspunkt der Verzweigung umfasst.

15. Verfahren nach den Ansprüchen 11 bis 14, wobei der Schritt der Analyse der überwachten elektrischen Eigenschaft, die von den an der Leitung montierten Sensoren empfangen wurde, weiter umfasst, dass die Fehlerortungseinheit die überwachte elektrischen Eigenschaft jedes an der Leitung montierten Sensors mit der überwachten elektrischen Eigenschaft von mindestens einem angrenzenden an der Leitung montierten Sensor vergleicht.

16. Verfahren nach Anspruch 15, wobei der Schritt zur Bestimmung, ob ein Fehler im Mittelspannungsnetzwerk vorliegt, die Bestimmung umfasst, ob eine Änderung der Differenz zwischen der überwachten elektrischen Eigenschaft eines an der Leitung montierten Sensors und eines angrenzenden an der Leitung montierten Sensors über einen vorbestimmten Schwellenwert vorliegt.

17. Verfahren nach den Ansprüchen 11 bis 16, wobei der Schritt zur Bestimmung des Ortes des Fehlers den ersten Schritt der Bestimmung umfasst, ob der Fehler auf der Verzweigung oder der Hauptbahn (9) vorliegt, und wobei bei der Bestimmung, dass der Fehler auf der Verzweigung vorliegt, der Schritt der Bestimmung des Ortes des Fehlers weiter den nachfolgenden Schritt der Bestimmung der Entfernung des Fehlers von dem an der Leitung montierten Sensor umfasst, der sich vorgelagert vom Unterbrechungspunkt der Hauptbahn befindet.

18. Verfahren nach den Ansprüchen 11 bis 16, wobei der Schritt der Bestimmung des Ortes des Fehlers den anfänglichen Schritt der Bestimmung umfasst, ob der Fehler auf der Verzweigung oder der Hauptbahn vorliegt, und wobei bei der Bestimmung, dass der Fehler auf der Hauptbahn (9) vorliegt, der Schritt der Bestimmung des Ortes des Fehlers den nachfolgenden Schritt der Bestimmung der Entfernung des Fehlers vom an der Leitung montierten Sensor umfasst, der sich nachgelagert vom Unterbrechungspunkt der Hauptbahn befindet.

19. Verfahren nach den Ansprüchen 11 bis 18, wobei die an der Leitung montierten Sensoren jeweils den Leitungsstrom messen.

20. Verfahren nach den Ansprüchen 11 bis 19, wobei die an der Leitung montierten Sensoren jeweils die Leitungsspannung messen.

21. Verfahren nach den Ansprüchen 11 bis 20, wobei das Mittelspannungsnetzwerk weiter einen Umspannwerksensor (33) umfasst, der die offene Dreiecksspannung des Umspannwerks misst und die offene Dreiecksspannung an die Fehlerortungseinheit übermittelt.

22. Verfahren nach den Ansprüchen 11 bis 21, wobei jeder an der Leitung montierte Sensor einen zugeordneten und damit in Kommunikation stehenden Regler aufweist, wobei der an der Leitung montierte Sensor mit der Fehlerortungseinheit durch den damit zugeordneten Regler kommuniziert, und wobei ein einzelner Regler an jedem Unterbrechungspunkt der Hauptbahn oder der Verzweigung bereitgestellt ist, wobei der einzelne Regler beiden an der Leitung montierten Sensoren unmittelbar neben dem Unterbrechungspunkt zugeordnet ist und in Kommunikation damit steht, und beide dieser an der Leitung montierten Sensoren mit der Fehlerortungseinheit durch den damit zugeordneten Regler kommunizieren.

23. Verfahren nach den Ansprüchen 11 bis 22, wobei jeder Sensor der Fehlerortungseinheit phasenkohärente Proben mit mehreren Zyklen zur Analyse bereitstellt.

**Revendications**

1. Système (21) pour la localisation de défauts de ligne dans un réseau moyenne tension (3), le réseau moyenne tension comprenant une sous-station et une pluralité de lignes électriques porteuses d'électricité (7) s'étendant vers l'extérieur de celle-ci, les lignes électriques étant disposées dans une configuration d'arbre présentant une colonne centrale (9) et une pluralité de ramifications (10(a) - 10(e)) se séparant de la colonne centrale sur des points de rupture de colonne (11(a) - 11(e)) ; le système comprenant une pluralité de capteurs montés sur ligne (23(a) - 23(l)) distribués sur les lignes électriques surveillant une propriété électrique de la ligne électrique sur laquelle ils sont montés, et une unité de localisation de défaut (15) en communication avec chacun des capteurs montés sur ligne, l'unité de localisation de défaut présentant un processeur pour analyser des données reçues des capteurs montés sur ligne ; **caractérisé en ce que** :
il est prévu une paire de capteurs montés sur ligne (23(a)) - 23(l)) montés sur la colonne sur le point de rupture de colonne sur chacun des points de rupture de colonne (11(a) -11(e)), dont un est en amont du point de rupture de colonne, dont l'autre est en aval du point de rupture de colonne.

2. Système (21) selon la revendication 1, dans lequel les paires de capteurs montés sur ligne (23(a)) - 23(l)) sont montées sur la colonne immédiatement adjacente au point de rupture de colonne (11(a) - 11(e)).

3. Système (21) selon la revendication 1 ou 2, dans lequel au moins une des ramifications présente une branche (14a, 14b) se séparant de celle-ci sur un point de rupture de ramification (29(a)), et dans lequel il est prévu une paire de capteurs montés sur ligne (23(k), 23(l)) montés sur la ramification sur le point de rupture de ramification, dont un est en amont du point de rupture de ramification, dont l'autre est en aval du point de rupture de ramification.

4. Système (21) selon la revendication 3, dans lequel la paire de capteurs montés sur ligne (23(k), 23(l)) montés sur la ramification est montée sur la ramification immédiatement adjacente au point de rupture de ramification.

**5.** Système (21) selon l'une quelconque des revendications précédentes, dans lequel les capteurs montés sur ligne comprennent chacun un capteur de courant pour mesurer le courant de ligne.

**6.** Système (21) selon l'une quelconque des revendications précédentes, dans lequel les capteurs montés sur ligne comprennent chacun un capteur de tension pour mesurer la tension de ligne.

**7.** Système (31) selon l'une quelconque des revendications précédentes, dans lequel il est en outre prévu un capteur de sous-station (33) surveillant une propriété électrique du réseau moyenne tension (3) sur la sous-station et dans lequel l'unité de localisation de défaut est en communication avec le capteur de sous-station.

**8.** Système (31) selon la revendication 7, dans lequel le capteur de sous-station comprend un capteur de tension en triangle ouvert.

**9.** Système (21, 31) selon l'une quelconque des revendications précédentes, dans lequel chaque capteur monté sur ligne présente un élément de commande associé et en communication avec celui-ci, le capteur monté sur ligne communiquant avec l'unité de localisation de défaut au travers de l'élément de commande associé à celui-ci, et dans lequel il est prévu un seul élément de commande sur chaque point de rupture, le seul élément de commande étant associé et en communication avec les deux des capteurs montés sur ligne immédiatement adjacents au point de rupture.

**10.** Système (21, 31) selon l'une quelconque des revendications précédentes, dans lequel chaque capteur fournit de multiples échantillons de cycle à phase cohérente à l'unité de localisation de défaut pour analyse.

**11.** Procédé de localisation de défauts de ligne dans un réseau moyenne tension (3), le réseau moyenne tension comprenant une sous-station et une pluralité de lignes électriques porteuses d'électricité (7) s'étendant vers l'extérieur de celle-ci, les lignes électriques étant disposées dans une configuration d'arbre présentant une colonne centrale (9) et une pluralité de ramifications (10(a) - 10(e)) se séparant de la colonne centrale sur des points de rupture de colonne (11(a) - 11(e)) ; le système comprenant une pluralité de capteurs montés sur ligne (23(a) - 23(l)) distribués sur les lignes électriques surveillant une propriété électrique de la ligne électrique sur laquelle ils sont montés, et une unité de localisation de défaut en communication avec chacun des capteurs montés sur ligne, l'unité de localisation de défaut présentant un processeur pour analyser des données reçues des capteurs montés sur ligne, le procédé comprenant les étapes de :

(a) sur chaque point de rupture de colonne (11(a) - 11(e)) la surveillance de la propriété électrique de la ligne électrique en amont du point de rupture de colonne et la transmission de la propriété électrique surveillée depuis l'amont du point de rupture de colonne à l'unité de localisation de défaut ;
(b) sur chaque point de rupture de colonne (11(a) - 11(e)) la surveillance de la propriété électrique de la ligne électrique en aval du point de rupture de colonne et la transmission de la propriété électrique surveillée depuis l'aval du point de rupture de colonne à l'unité de localisation de défaut ;
(c) l'unité de localisation de défaut analysant la propriété électrique surveillée reçue des capteurs montés sur ligne et déterminant s'il y a un défaut sur le réseau moyenne tension ; et
(d) pour le fait de déterminer s'il y a un défaut dans le réseau moyenne tension, l'unité de localisation de défaut déterminant l'emplacement du défaut sur le réseau moyenne tension.

**12.** Procédé selon la revendication 11, dans lequel le procédé comprend la surveillance de la propriété électrique de la ligne électrique immédiatement adjacente au point de rupture de colonne (11(a) - 11(e)).

**13.** Procédé selon la revendication 11 ou 12, dans lequel au moins une des ramifications présente une branche se séparant de celle-ci sur un point de rupture de ramification, et dans lequel le procédé comprend en outre les étapes de :

(e) sur chaque point de rupture de ramification la surveillance de la propriété électrique de la ligne électrique en amont du point de rupture de ramification et la transmission de la propriété électrique surveillée depuis l'amont du point de rupture de ramification à l'unité de localisation de défaut ; et
(f) sur chaque point de rupture de ramification la surveillance de la propriété électrique de la ligne électrique en aval du point de rupture de ramification et la transmission de la propriété électrique surveillée depuis l'aval du point de rupture de ramification à l'unité de localisation de défaut.

14. Procédé selon la revendication 13, dans lequel le procédé comprend la surveillance de la propriété électrique de la ligne électrique (7) immédiatement adjacente au point de rupture de ramification.

15. Procédé selon les revendications 11 à 14, dans lequel l'étape d'analyse de la propriété électrique surveillée reçue des capteurs montés sur ligne comprend en outre l'unité de localisation de défaut comparant la propriété électrique surveillée de chaque capteur monté sur ligne avec la propriété électrique surveillée d'au moins un capteur monté sur ligne adjacent.

16. Procédé selon la revendication 15, dans lequel l'étape de détermination s'il y a un défaut sur le réseau moyenne tension comprend le fait de déterminer s'il y a un changement dans la différence entre la propriété électrique surveillée d'un capteur monté sur ligne et d'un capteur monté sur ligne adjacent au-dessus d'un seuil prédéterminé.

17. Procédé selon les revendications 11 à 16, dans lequel l'étape de détermination de l'emplacement du défaut comprend l'étape initiale de détermination si le défaut est sur la ramification ou sur la colonne (9), et dans lequel pour le fait de déterminer si le défaut est sur la ramification, l'étape de détermination de l'emplacement du défaut comprend en outre l'étape ultérieure de détermination de la distance du défaut du capteur monté sur ligne situé en amont du point de rupture de colonne.

18. Procédé selon les revendications 11 à 16, dans lequel l'étape de détermination de l'emplacement du défaut comprend l'étape initiale de détermination si le défaut est sur la ramification ou sur la colonne, et dans lequel pour le fait de déterminer si le défaut est sur la colonne (9), l'étape de détermination de l'emplacement du défaut comprend en outre l'étape ultérieure de détermination de la distance du défaut du capteur monté sur ligne situé en aval du point de rupture de colonne.

19. Procédé selon les revendications 11 à 18, dans lequel les capteurs montés sur ligne mesurent chacun le courant de ligne.

20. Procédé selon les revendications 11 à 19, dans lequel les capteurs montés sur ligne mesurent chacun la tension de ligne.

21. Procédé selon les revendications 11 à 20, dans lequel le réseau moyenne tension comprend en outre un capteur de sous-station (33) qui mesure la tension en triangle ouvert de sous-station et transmet la tension en triangle ouvert à l'unité de localisation de défaut.

22. Procédé selon les revendications 11 à 21, dans lequel chaque capteur monté sur ligne présente un élément de commande associé et en communication avec celui-ci, le capteur monté sur ligne communiquant avec l'unité de localisation de défaut au travers de l'élément de commande associé à celle-ci et dans lequel il est prévu un seul élément de commande sur chaque point de rupture de colonne ou de ramification, le seul élément de commande étant associé et en communication avec les deux des capteurs montés sur ligne immédiatement adjacents au point de rupture et les deux de ces capteurs montés sur ligne communiquant avec l'unité de localisation de défaut au travers de l'élément de commande associé à celle-ci.

23. Procédé selon les revendications 11 à 22, dans lequel chaque capteur fournit de multiples échantillons de cycle à phase cohérente à l'unité de localisation de défaut pour analyse.

Fig. 1

Fig. 2

Fig. 3

Fig. 4

41

3

10(a)

11(a)

7

5

23(a)

9

15

43

10(e)

23(l)

14(a)

14(b)

29(a)

23(k)

10(c)

11(c)

11(b)

10(b)

23(e)

23(c)

11(d)

23(g)

10(d)

11(e)

23(i)

23(h)

9

23(j)

Phase A, I ⟶ 51(a)

Phase B, I ⟶ 51(b)

Phase C, I ⟶ 51(c)

Phase A, V ⟶ 53(a)

Phase B, V ⟶ 53(b)

Phase C, V ⟶ 53(c)

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004068151 A
- WO 2005119277 A

- WO 2007135162 A

**Non-patent literature cited in the description**

- **M. SANAYE-PASAND ; H. KHORASHADI-ZADEH.** *Transmission Line Fault Detection and Phase Selection Using ANN*

- **TAHAR BOUTHIBA.** Fault Location in EHV Transmission Lines Using Artificial Neural Networks. *International Journal of Applied Mathematics and Computer Science,* 2004, vol. 14 (1), 69-78